(19) Europäisches Patentamt
European Patent Office
Office européen des brevets

(11) **EP 2 894 580 A1**

(12) **EUROPEAN PATENT APPLICATION**

(43) Date of publication:
**15.07.2015 Bulletin 2015/29**

(51) Int Cl.:
***G06F 17/50*** *(2006.01)*

(21) Application number: **14275004.1**

(22) Date of filing: **10.01.2014**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(71) Applicant: **BAE Systems PLC**<br>**London SW1Y 5AD (GB)** | (72) Inventor: **The designation of the inventor has not yet been filed**<br><br>(74) Representative: **BAE SYSTEMS plc**<br>**Group IP Department**<br>**Farnborough Aerospace Centre**<br>**Farnborough**<br>**Hampshire GU14 6YU (GB)** |

(54) **Assessment of assemblies**

(57)     Disclosed are a method and apparatus for providing an assessment of the effects of a lightning strike on an assembly (2, 20), such as a structural joint assembly of an aircraft. The method comprises: acquiring values for a plurality of physical properties of the assembly (2, 20); using the acquired values, generating a digital model of an electrical circuit (22) representative of the assembly (2, 20); applying, to the digital model, an input so as to simulate a predetermined current being applied to the electrical circuit (22), the predetermined current being a current generated by a lightning strike; determining an effect of the input on at least a portion of the digital model; and, using the determined effect, determining the assessment of the assembly (2, 20).

Fig. 1

EP 2 894 580 A1

**Description**

FIELD OF THE INVENTION

The present invention relates to the assessment of the effects of lightning strikes on assemblies.

BACKGROUND

When lightning strikes an aircraft, a portion of the strike current passes around the exterior skin of the aircraft, and a portion passes through the aircraft structure.

With the advent of composite skins, a larger proportion of the current passes through metallic structures and the joint assemblies that connect together sections of those structures.

Effects on joint assemblies range from no effect at all, to sparking, degradation due to the overheating of non-metallic shim materials, degradation due to the overheating of metallic components, destruction of fasteners, or even explosive destruction of the joint assembly itself.

The effects of a lightning strike on a joint assembly depend upon a number of factors including, but not limited to, the configuration of the component parts in the joint assembly.

Conventionally, assessing the threat lightning poses to a joint assembly involves expensive and time consuming testing. Such testing typically requires manufacture of articles representative of the joint assembly under test, assessment of the lightning threat, and testing of the articles at a suitably equipped laboratory.

SUMMARY OF THE INVENTION

In a first aspect, the present invention provides a method of providing an assessment of the effects of a lightning strike on an assembly, the method comprising: acquiring values for a plurality of physical properties of the assembly; using the acquired values, generating a digital model of an electrical circuit representative of the assembly; applying, to the digital model, an input so as to simulate a predetermined current being applied to the electrical circuit, the predetermined current being a current generated by a lightning strike; determining an effect of the input on at least a portion of the digital model; and, using the determined effect, determining the assessment of the assembly.

The digital model of the electrical circuit may comprise digital models of a plurality of electrical components selected from the group consisting of resistors, inductors, and capacitors. The electrical properties of the electrical components may be determined using the acquired physical properties of the assembly such that the electrical circuit is substantially electrically equivalent to the assembly.

The method may further comprise determining the predetermined current. The predetermined current may be determined using a double exponential waveform having a magnitude and waveform that may be determined by assessing an overall structure of which the assembly is a part. The predetermined current may be determined by determining the number of parallel electrical paths that exist within an overall structure of which the assembly is a part from a lightning strike location to an exit location of the lightning current, and dividing a lightning current between those parallel paths (e.g. proportionally according to the respective resistances of the paths).

The assembly may be a joint assembly comprising at least two components fixedly attached together. The two components may be fixedly attached together by means of fasteners passing at least partially through each of the at least two components and/or by means of a sealant. The joint assembly may be an aircraft structural joint assembly that couples together two component parts of an aircraft substructure or airframe.

The step of acquiring values for a plurality of physical properties of the assembly may comprises providing at least part of the assembly, and measuring, using a measurement device, the at least part of the assembly so as to determine values for one or more of the physical properties. Alternatively, values for a plurality of physical properties of the assembly may be acquired from design data or manufacturer's specifications.

The method may further comprise, using the assessment of the assembly, modifying the assembly, for example, to improve its lightning strike performance.

At least one physical property of the assembly may be a physical property selected from the group of physical properties consisting of: a physical dimension of at least part of the assembly, a dielectric strength of at least part of the assembly, a resistance through at least part of the assembly, an inductance through at least part of the assembly, a capacitance of at least part of the assembly, a resistivity of at least part of the assembly, a permittivity of at least part of the assembly, a breakdown voltage of at least part of the assembly, and a material from which of at least part of the assembly is made.

At least part of the assembly may be represented in the digital model by a plurality of nodes connected together in series and a plurality of nodes connected together in parallel. Each node may comprise a digital model of a resistor coupled (e.g. in series) to an inductor.

In a further aspect, the present invention provides a method of comparing two of more assemblies, the method comprising: for each assembly, determining an assessment of that assembly by performing, for that assembly, an assessment method according to the first aspect; and, using the determined assessments, comparing the assemblies.

In a further aspect, the present invention provides apparatus for providing an assessment of the effects of a lightning strike on an assembly, the apparatus comprising: means for acquiring values for a plurality of physical properties of the assembly; and one or more processors configured to: using the acquired values, generate a digital model of an electrical circuit representative of the assembly; apply, to the digital model, an input so as to simulate a predetermined current being applied to the electrical circuit, the predetermined current being a current generated by a lightning strike; determine an effect of the input on at least a portion of the digital model; and, using the determined effect, determine the assessment of the assembly.

In a further aspect, the present invention provides a program or plurality of programs arranged such that when executed by a computer system or one or more processors it/they cause the computer system or the one or more processors to operate in accordance with the method of any of the above aspects.

In a further aspect, the present invention provides a machine readable storage medium storing a program or at least one of the plurality of programs according to the preceding aspect.

BRIEF DESCRIPTION OF THE DRAWINGS

Figure 1 is a schematic illustration (not to scale) of a cross section of a first example joint assembly;

Figure 2 is a schematic illustration (not to scale) of a cross section of a second example joint assembly;

Figure 3 is a process flow chart showing certain steps of an embodiment of a joint assembly analysis process;

Figure 4 is a schematic illustration (not to scale) showing an example electrical circuit;

Figure 5 is a schematic illustration (not to scale) showing electrical components representative of a fastener in the first example joint assembly; and

Figure 6 is a schematic illustration (not to scale) showing a electrical components representative of a fastener in the second example joint assembly.

DETAILED DESCRIPTION

In the following description, like reference numerals refer to like elements.

The following description is based on embodiments of the invention and should not be taken as limiting the invention with regard to alternative embodiments that are not explicitly described herein.

It will be appreciated that relative terms such as top and bottom, and so on, are used merely for ease of reference to the Figures, and these terms are not limiting as such, and any two differing directions or positions and so on may be implemented.

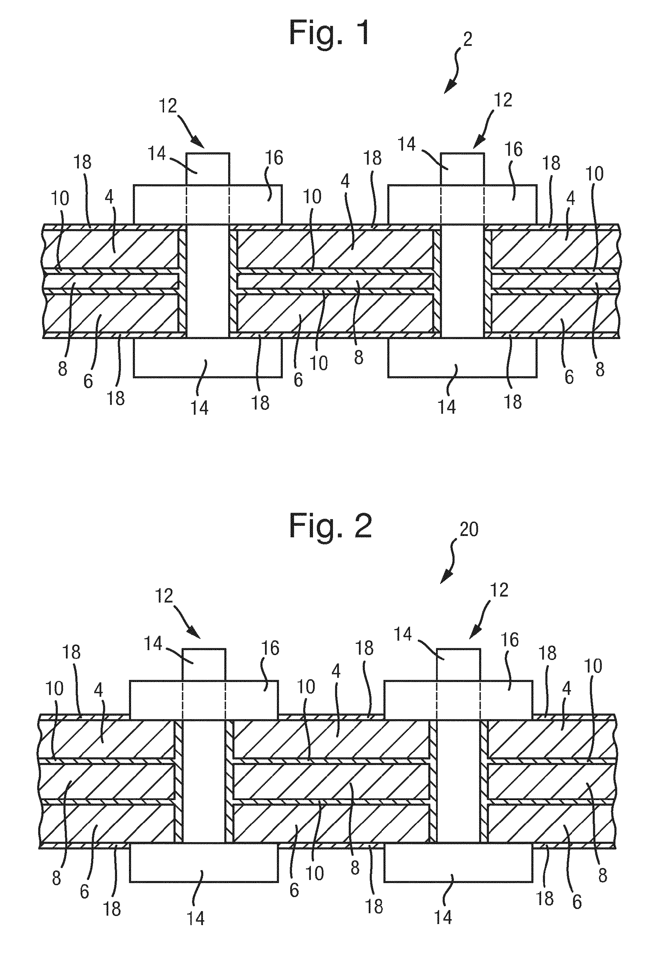

Figure 1 is a schematic illustration (not to scale) of a cross section of a first example joint assembly, hereinafter referred to as the "first joint assembly" and indicated in the Figures by the reference numeral 2, which will be used to illustrate an embodiment of a joint assembly analysis process.

In this embodiment, the first joint assembly 2 is onboard an aircraft.

The first joint assembly 2 comprises a first layer of material 4 fixedly coupled to a second layer of material 6. The first layer of material 4 is part of an airframe or substructure of the aircraft and may be made of titanium. The second layer of material 6 is part of an airframe or substructure of the aircraft and may be made of titanium.

In this embodiment, a metallic shim 8 is disposed between the first layer 4 and second layer 6. The metallic shim 8 may be made of titanium.

In the first joint assembly 2, the first layer 4, the second layer 6, and the metallic shim 8 have been wet assembled together using a sealant 10. The sealant 10 is relatively non-conductive compared to the first layer 4, the second layer 6, and the metallic shim 8. The sealant 10 is disposed between the first layer 4 and the metallic shim 8, and between the metallic shim 8 and the second layer 6.

In the first joint assembly 2, two fasteners 12 also hold together the first layer 4 and the second layer 6. Each fastener 12 comprises a bolt 14, a shaft of which extends through the first layer 4, the second layer 6, and the metallic shim 8, from a bottom surface of the second layer 6, to a top surface of the first layer. Each fastener 12 further comprises a nut 16 which is attached to a respective bolt 14 at a top surface of the first layer 4, so as to secure that bolt 14 in place. The nuts 16 of the fasteners 12 may have been tightened on to the respective bolt 14 to a predetermined torque.

Preferably, the sealant 10 electrically isolates the first layer 4 from the shafts of the bolts 14. Also, the sealant 10 electrically isolates the second layer 4 from the shafts of the bolts 14. In some cases tightening of the fasteners 12 may causes some contact between the fasteners 12 and the first later 4, the shim 8 and/or the second layer 6.

In this embodiment, the first joint assembly 2 further comprises layers of a protective coating 18 disposed on the top surface of the first layer 4 and on the bottom surface of the second layer 6. The protective coating 18 may be a paint or other substance which is relative electrically non-conductive. The protective coating 18 may be a primer. The protective coating 18 on the top surface of the first layer 4 electrically isolates the first layer 4 from the fasteners 12. Similarly, the protective coating 18 on the bottom surface of the second layer 6 electrically isolates the second layer 6 from the fasteners 12.

Figure 2 is a schematic illustration (not to scale) of a cross section of a second example joint assembly, hereinafter referred to as the "second joint assembly" and indicated in the Figures by the reference numeral 20, which will be used to illustrate an embodiment of a joint assembly analysis process.

The elements of the second joint assembly 20 are arranged in the same way as in the first joint assembly 2, as described in more detail above with reference to Figure 1, except that, in the second joint assembly 20, the protective layer 18 does not electrically isolate the first layer 4 from the nut 16. In other words, in the second joint assembly 20, the first and second layers are each in electrical contact with the nut 16.

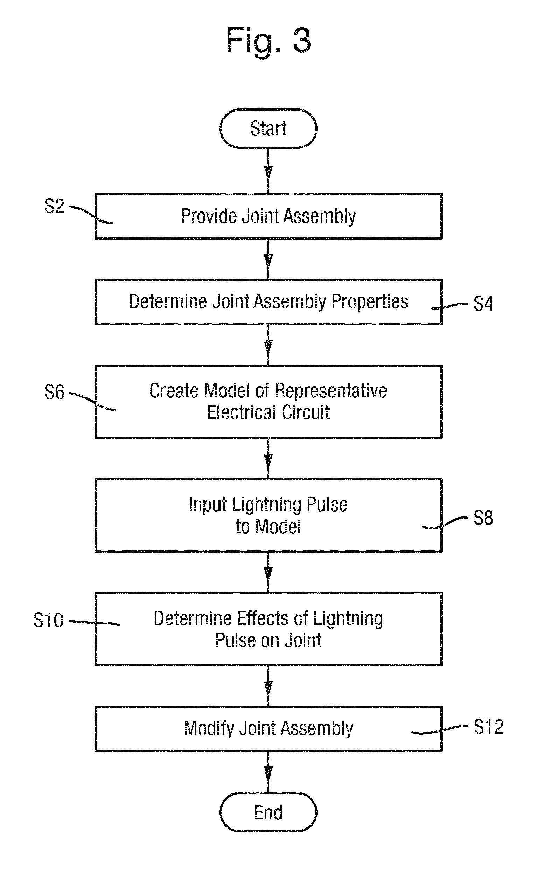

Figure 3 is a process flow chart showing certain steps of an embodiment of a joint assembly analysis process which may be performed to assess the joint assemblies 2, 20. Assessments of the joint assemblies 2, 20 may be used to compare the joint assemblies to each other.

At step s2, a joint assembly 2, 20 is provided.

At step s4, various physical properties of the provided joint assembly 2, 20 are determined or acquired.

Joint assembly properties may be determined from design data, manufacturer's specifications, or by taking measurements of the joint assembly 2, 20 as a whole, and/or the individual components that make up the provided joint assembly 2, 20.

The following information is useful for understanding which joint assembly properties are acquired, and how those properties may be acquired. Step s6 of the process, at which the determined properties are used to create an electrical circuit equivalent to the joint assembly 2, 20, will be described in more detail later below after discussion of the joint assembly properties.

Joint assembly properties that may be determined may include, but are not limited to, thicknesses of the layers of material in the joint assembly 2, 20, dielectric properties of the components of the joint assemblies 2, 20, the materials from which the components of the joint assembly 2, 20 are made, and the dimensions of the fasteners 12 of the joint assembly 2, 20.

The DC resistance through a joint assembly 2, 20 may be as a result of small patches of (e.g. metallic) contact between the first layer 4 and the metallic shim 8 and between the metallic shim 8 and the second layer 6, where the inherent roughness of the surfaces of the layers 4, 6, 8 penetrate the sealant film 10 within a certain area.

In this embodiment, these contacts between layers 4, 6, 8 are considered to be a set of $n$ circles, each having diameter $d$. The circles are distributed across a circular contact area of diameter $D$. The circles represent contacts between surfaces of resistivity $p$.

In this embodiment, the resistance through a joint assembly 2, 20 is approximated as:

$$R \approx \frac{\rho}{D} + \frac{\rho}{nd}$$

where: $\rho$ is the resistivity of the joint assembly 2, 20 (i.e. through the first and second layers 4, 6, and the metallic shim 8);

$D$ is the effective radius of the area over which contact between the layers in the joint assembly 2, 20 occurs;

$n$ is the number of contact circles; and

$d$ is the mean radius of the contact circles.

Further information about this expression may be found, for example in "Contact Resistance Calculations:

Generalizations of Greenwood's Formula Including Interface Films", L. Boyer, IEEE transactions on components and packaging technologies, Vol. 24, No.1, March 2001, which is incorporated herein in its entirety be reference.

Thus, an effective cross sectional contact area between the layers 4, 6, 8 in a joint assembly 2, 20 may expressed as:

$$ nd = \frac{D\rho}{DR - \rho} $$

Thus, using determined joint assembly properties, *nd* may be calculated.

In addition to contact between the layers 4, 6, 8 within the joint assembly 2, 20, there may be contact between the shaft of the bolt 14 and one or more of the layers 4, 6, 8.

Assuming that the contact between shaft of the bolt 14 and the layers 4, 6, 8 forms a single circle for each layer 4, 6, 8 whose diameter is set by the thickness of that layer 4, 6, 8, the contact between the bolt 14 and the layers 4, 6, 8 can be modelled in an analogous way to that described above for modelling contact between the layers 4, 6, 8.

When a joint assembly 2, 20 is struck by lightning, the lightning current tends to enter the joint via the upper/top surface of the first layer 4. Also, electrical charge flows into the attachment location and voltages are formed between certain locations within the joint assembly 2, 20.

For example, in the first joint assembly 2, there is an electrical connection between the first and second layers 4, 6, in two series stages via the metallic shim 8. As mentioned earlier above, this electrical contact corresponds to a certain contact area.

Also for example, in the second joint assembly 20, in addition to the electrical connection between the first and second layers 4, 6, in two series stages via the metallic shim 8, there is additionally electrical connection between the first layer 4 and the fasteners 12 via the contact between the top surface of the first layer 4 and the underside of the nut 16. A diameter of a circle representing this contact area between the fasteners 12 at the first layer 4 may be calculated as mentioned earlier above.

The thickness of each sealant layer 10 may be specified from, for example, manufacturing tolerances.

The dielectric strength of the sealant 10 may be determined by measurement or from a manufacturer's specification. This parameter value may be expressed kV/mm. The permittivity of the sealant 10 is may also be determined.

The capacitance of the joint assembly 2, 20 can be calculated, for example, using the following expression:

$$ C = \varepsilon_0 \varepsilon_r \frac{A}{d_l} $$

where: $\varepsilon_0$ is the permittivity of free space, e.g. $8.8542 \times 10^{-12}$ Fm$^{-1}$;

$\varepsilon_r$ is the relative permittivity of the sealant 10;

*A* is the combined area formed between the first layer 4 and the shim 8 and between the shim 8 and the second layer 6; and

$d_l$ is the thickness of the sealant in the joint.

The inductance of rectilinear components of the joint assembly 2, 20 may be determined using the following expression:

$$L = 0.002l \left( \log\left(\frac{2l}{D}\right) - 1 + \frac{D}{l} \right)$$

where: L may be given in microHenries (μH);

*l* is the length (e.g. in cm) of the relevant conductor; and

D =(0.2235(a+b), is a geometric mean distance (e.g. in cm), where a and b are the orthogonal dimensions of the conductor cross section

Further information about the above expression and the determination of the joint assembly capacitance may be found, for example, in E. Rosa, "The self and mutual inductance of linear conductors," Bull., National Bureau of Standards, pp. 301-344, 1908, which is incorporated herein in its entirety be reference.

The resistance of the components of the joint assembly 2, 20 may be calculated using the following expression:

$$R_c = \frac{\rho_c L_c}{A_c}$$

where: $R_c$ is the resistance of component c;

$\rho_c$ is the resistivity of component c;

$L_c$ is the inductance of the component c; and

$A_c$ is the cross sectional area of component c.

A breakdown voltage of the joint assembly 2, 20 may be calculated from the thickness and dielectric strength of the sealant 10.

The cross sectional area of the shafts of the bolts 14, the lengths of the bolts 14 from bolt head to nut 16 contact surfaces, and any gaps in the joint assembly 2, 20 may be determined, for example from design data or by measuring.

An inductance for the fasteners 12, i.e. an inductance of the portion of the shafts of the bolts 14 through which electrical charge may flow, can be determined using:

$$L = 0.002l_b \left( \log\left(\frac{l_b + \sqrt{l_b^2 + r_b^2}}{r_b}\right) - \sqrt{l_b^2 + r_b^2} + \frac{l_b}{4} + r_b \right) \mu H$$

where:

$l_b$ is the length of the relevant portion of the shaft of the bolt 14; and
$r_b$ is the radius of the shaft of the bolt 14.

Further information about the above expression and the determination of the joint assembly capacitance may be found, for example, in E. Rosa, "The self and mutual inductance of linear conductors," Bull., National Bureau of Standards, pp. 301-344, 1908, which is incorporated herein in its entirety be reference.

The resistance of the shafts of the bolts 14 may be calculated using:

$$R_b = \frac{\rho_b L_b}{A_b}$$

where: $R_b$ is the resistance of the shaft of a bolt 14;

$\rho_b$ is the resistivity of the shaft of a bolt 14;

$L_b$ is the inductance of the shaft of a bolt 14; and

$A_b$ is the cross sectional area of the shaft of a bolt 14.

The thickness, dielectric strength and permittivity of the protective coating 18 may be acquired, for example, from a manufacturer's specification, or determined, for example, via experimentation.

The inductance and resistance of a single contact point (between the layers 4, 6, 8) may be calculated using expressions for inductance and resistance analogous to those provided above.

In the first joint assembly 2 there is no bonding between the nut 16 and the first layer 4 due to the presence of the protective coating 18. Thus, the nut 16 and first layer 4 form a capacitance which is defined by the gap between the metal surfaces, the surface area involved, and the dielectric properties of the protective coating 18. This capacitance can be calculated using an expression for capacitance analogous to that provided above. A breakdown voltage between the nut 16 and the first layer 4 may be calculated from the thickness and dielectric strength of the protective coating 18. The resistance of the electrical contact between the nut 16 and the first layer 4 that occurs as a result of such a breakdown may be calculated by:

$$R_{ring} = \frac{\rho}{d_2} + \frac{\rho}{d_2 - d_1}$$

where: p is the resistivity of the fastener 12;

$d_1$ is the radius of the shaft of the bolt 14; and

$d_2$ is the outer radius of the nut 16.

At step s6, using the properties of the joint assembly 2, 20 and its components measured/determined at step s4, an electrical circuit that is representative of, i.e. electrically equivalent to, the joint assembly 2, 20 is determined. The measured/determined dimensions of the components of the joint assembly 2, 20 may be used to estimate the inductances and capacitances within the electrical circuit.

In this embodiment, the electrical circuit has all relevant electrical characteristics of the joint assembly 2, 20 being assessed.

In this embodiment, the model of the electrical circuit is a digital model created by a user using a computer and any appropriate software package.

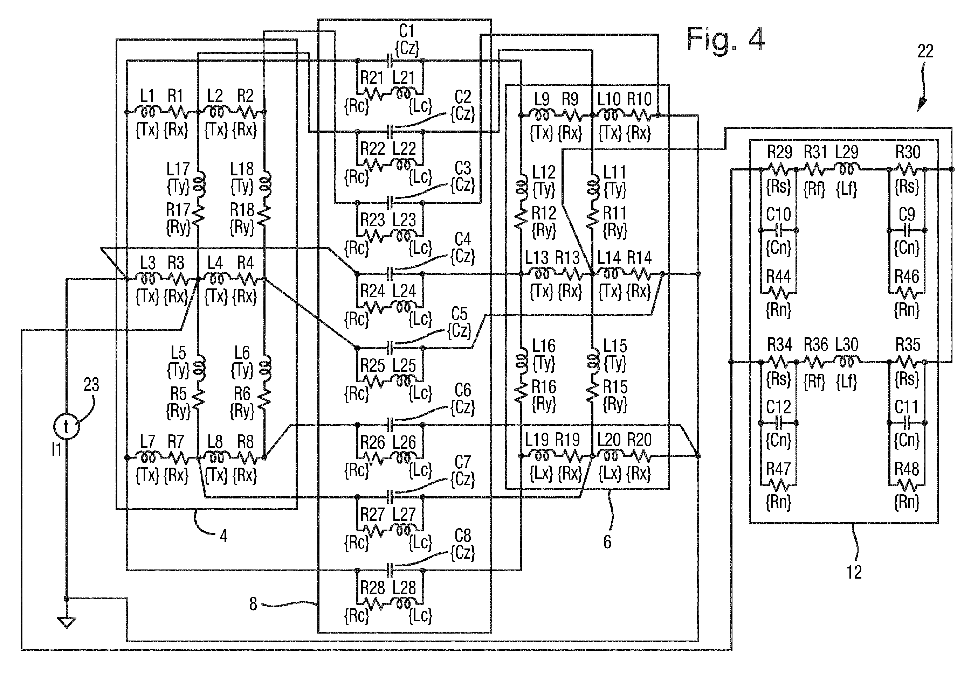

Figure 4 is a schematic illustration (not to scale) showing an example electrical circuit 22 that is electrically equivalent to the first joint assembly 2.

In this embodiment, the electrical circuit 22 comprises a plurality of resistors, inductors and capacitors. The resistances of each of the resistors may be specified based on the joint properties determined earlier at step s4. The inductances of each of the inductors may be specified based on the joint properties determined earlier at step s4. The capacitances of each of the capacitors may be specified based on the joint properties determined earlier at step s4.

In this embodiment, the electrical circuit 22 further comprises an input 23 to which a simulated input current may be applied.

In this embodiment, the electrical circuit 22 comprises a plurality of lattices. Each lattice is a discretised representation of the joint materials, connected by inductances, resistances and capacitances. The electrical circuit is an advantageously compact representation of the first joint assembly 2 which includes all the features used in the joint analysis process.

The lattice of the electrical circuit 22 that is representative of the first layer 4 is shown in Figure 4 inside a box marked with the reference numeral 4.

The lattice of the electrical circuit 22 that is representative of the second layer 6 is shown in Figure 4 inside a box marked with the reference numeral 6.

The lattice of the electrical circuit 22 that is representative of the contact between the first layer 4 and the second layer 6 via the metallic shim 8 is shown in Figure 4 inside a box marked with the reference numeral 8.

The lattice of the electrical circuit 22 that is representative of electrical contact through the first joint assembly 2 via the fasteners 12 is shown in Figure 4 inside a box marked with the reference numeral 12.

In this embodiment, in the electrical circuit 22, each of the first and second layers of material 4, 6 are represented by a lattice of nodes, the nodes comprising a resistor coupled in series with an inductor. Each of the first and second layers 4, 6 comprise, in the x-direction, three of these nodes connected in parallel and two of these nodes connected in series. Also, each of the first and second layers 4, 6 comprise, in the y-direction, two of these nodes connected in parallel and two of these nodes connected in series.

In this embodiment, the lattices representing the first and second layers 4, 6 are modelled to be connected via eight contact points representing contact between the two layers 4, 6 through the metallic shim 8 (shown in Figure 4 within the box labelled with the reference numeral 8), plus an additional contact point representing contact between the two layers 4, 6 via the fasteners 12 (shown in Figure 4 within the box labelled with the reference numeral 12). In other embodiments, there may be a different number of contact points.

In this embodiment, the impedances of the eight contact points representing contact between the two layers 4, 6 through the metallic shim 8 combine to that calculated in step s4 above.

In this embodiment, eight contact points are present between the first layer 4 and the second layer 6 via the shim 8 and sealant 10. Also, these contact points act in parallel to each other. Thus, in this embodiment each resistance and inductance may be calculated by the scaling of the joint impedance by the number of nodes (i.e. by eight). Also, each capacitance may be calculated by dividing the capacitance between the faces of the first layer 4 and the metallic shim 8 and the metallic shim 8 and the second layer 6, by the number of nodes (i.e. by eight). This tends to provide that the combined impedance is equal to the overall joint impedance as calculated in step s4 above. The embodiment may be easily varied to facilitate the investigation of different joint realisations, for example, to account for a single point contact rather than a distribution of contacts. In other embodiments, a different number (e.g. more than eight) of contact points are present between the first layer 4 and the second layer 6 via the shim 8 and sealant 10.

In this embodiment, the fasteners 12 are represented in the electrical circuit 22 by a combination of resistors, capacitors, and inductors (shown in Figure 4 within the box labelled with the reference numeral 12) that provide the resistances, inductances and capacitances of the fasteners 12 determined at step s4.

The reference symbols of the electrical circuit may be as follows: the input 23 may be the lightning current scaled for double exponential use; $Rx$ may be an X resistance per unit; $Ry$ may be a Y resistance per unit; $Ix$ may be an X inductance per unit; $Iy$ may be a Y inductance per unit; $Cz$ may be a joint capacitance per point; $Rc$ may be a joint resistance per point; $Lc$ may be a joint inductance per point; $Rf$ may be a fastener shank resistance; $Lf$ may be a fastener shank inductance; $Rs$ may be a shank contact resistance; $Rn$ may be a head/nut contact resistance; and $Cn$ may be a head/nut contact capacitance.

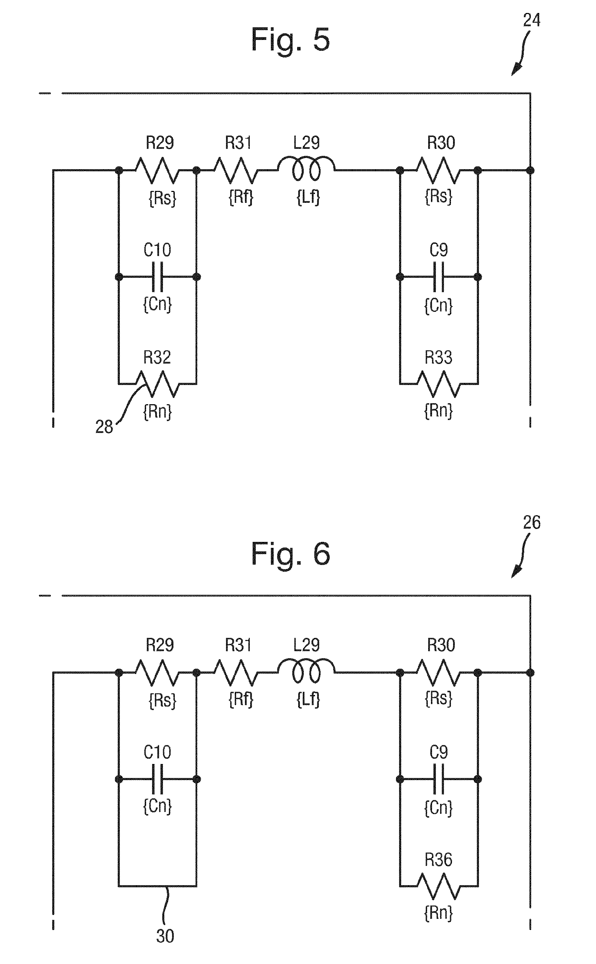

Figure 5 is a schematic illustration (not to scale) showing an example configuration (hereinafter referred to as the "first configuration" 24) of resistors, capacitors, and inductors representative of a fastener 12 in the first joint assembly 2.

Figure 6 is a schematic illustration (not to scale) showing an example configuration (hereinafter referred to as the "second configuration" 26) of resistors, capacitors, and inductors representative of a fastener 12 in the second joint assembly 20.

The first configuration 24 is the same as the second configuration 26, except that the first configuration 24 includes an additional resistor 28.

The additional resistor 28 models the electrical isolation between the nuts 16 and the first layer 4 within the first joint assembly 2 provided by the protective coating 18. Electrical arcing across this additional resistor 28 may occur.

The second configuration 26 includes a resistance free path 30 in place of this additional resistor 28. This resistance free path 30 models the electrical connection between the nuts 16 and the first layer 4 within the second joint assembly 20.

At step s8, a simulation process is performed. In this embodiment, this simulation process comprises, using the model of the electrical circuit 22, simulating a current representative of a lightning strike being applied to the input 23 of the electrical circuit 22. In this embodiment, this current is a double exponential waveform which may be described by the following expression:

$$I = A\left(\ell^{\alpha(-t)} - \ell^{\beta(-t)}\right)$$

Where

I is the current
A is the double exponentially adjusted amplitude
$\alpha$ and $\beta$ are coefficients chosen to give the waveform the correct shape in terms of rise time to peak and decay time to half; and
$t$ is time.

The peak current may be determined by an assessment of the overall structure of which the joint assembly 2, 20 is a part, by means of multipath analysis or computer modelling.

In some embodiments, the overall structure of which the joint assembly 2, 20 is a part may be assessed to determine the number of parallel paths that exist within the structure from the lightning strike location to the exit location of the lightning current. The lightning current may then be divided between those parallel paths (proportionally according to the respective resistances of those paths) to determine the current that flows through the joint assembly.

The simulation process may be performed using a computer and any appropriate circuit simulation tool.

At step s10, the effects on the electrical circuit 22 of inputting the current representative of the lightning strike are assessed.

In this embodiment, the circuit simulation tool is used first to calculate the voltages across various interfaces within the electrical circuit, and the field strengths developed in the materials involved, as a result of applying the input current

In this embodiment, the determined voltage between the fastener nut 16 and the first layer 4 is then used to generate a probability of breakdown occurring. This may be performed, for example, using a cumulative normal distribution with a mean of the estimated breakdown voltage and a standard deviation of one quarter of the breakdown voltage. In other embodiments, other information, for example other probabilities of breakdown occurring between other joint assembly components may be calculated.

In some embodiments, voltage controlled switches may be used in the circuit simulation to assess whether or not arcing across certain components occurs. Such voltage controlled switches may be specified using estimates of the dielectric strength of the materials within the joint assembly 2, 20.

In this embodiment, the circuit simulation tool is also used to calculate the current passing through various components of the assembly 2, 20 as represented by components of the electrical circuit, as a result of applying the input current. In other embodiments, other values may be calculated instead of or in addition to resultant currents, voltages and field strengths.

In this embodiment, calculations are performed in two states by means of multiple parameter values being specified, in order to assess the behaviour of the electrical circuit with and without electrical breakdown occurring between the nut 16 and first layer 4.

At step s12, the joint assembly 2, 20 may be modified or updated depending on the effects on the electrical circuit 22 representative of that joint assembly 2, 20 of inputting the current representative of the lightning strike.

Such modifications may include, but are not limited to, removing or adding fasteners 12, removing or adding a protective coating 18, increasing or decreasing the thickness of one or more of the layers 4, 6, 8, etc.

Such modification may be performed to improve the lightning strike performance of the joint assembly 2, 20.

In some embodiments, it is determined that the effect on the electrical circuit 22 of inputting the current representative of the lightning strike is a permitted outcome. In such cases, it may be decided that the joint assembly 2, 20 is not to be modified or updated.

Thus, an embodiment of a joint assembly analysis process is provided.

Advantageously, the above described method may be used to assess the differences between the lightning strike performances of different types of joint assemblies. For example, the above described method may be used to assess the differences between the effects of a lightning strike of the first joint assembly and the second joint assembly. Thus, a better performing joint assembly may be determined and implemented.

The above described method may be used to provide a rapid assessment of the effects of lightning strike on a joint assembly.

The use of a digital model to provide decision making data advantageously tends to reduce an amount of testing that is conventionally used to assess a joint assembly performance. In particular, the above described method advantageously tends to reduce or eliminate the use of destructive testing of joint assemblies.

Advantageously, the above described method exploits basic physical expressions and commonly available circuit modelling software to describe the paths that current may take through a joint assembly. The method allows different joint assembly options to be rapidly assessed in terms of the current conducted by joint components and the voltages developed across interfaces. Further, the method then allows for "arcing" to be simulated across interfaces in order to assess the changes in current distribution that result.

The above described method may be used to assess the damaging effects of currents or arcs, the necessity of various joint assembly practises, initial aircraft safety data, and any subsequent requirement for testing.

The above described analysis technique may advantageously be applied to assess the lightning response of any bolted joints, for example in aircraft, vehicles, ships or other structures.

Apparatus, including the computer for creating the digital model of the electrical circuit and for performing the simulation process, may be provided by configuring or adapting any suitable apparatus, for example one or more computers or other processing apparatus or processors, and/or providing additional modules. The apparatus may comprise a computer, a network of computers, or one or more processors, for implementing instructions and using data, including instructions and data in the form of a computer program or plurality of computer programs stored in or on a machine readable storage medium such as computer memory, a computer disk, ROM, PROM etc., or any combination of these or other storage media.

It should be noted that certain of the process steps depicted in the flowchart of Figure 3 and described above may be omitted or such process steps may be performed in differing order to that presented above and shown in Figure 3. Furthermore, although all the process steps have, for convenience and ease of understanding, been depicted as discrete temporally-sequential steps, nevertheless some of the process steps may in fact be performed simultaneously or at least overlapping to some extent temporally.

In the above embodiments, the joint assembly analysis process is used to assess joint assemblies as described above with reference to Figures 1 and 2. The first and second joint assemblies are joint assemblies onboard aircraft. However, in other embodiments, the joint assembly analysis process is used to assess one or more different types of assembly. For example, a joint assembly onboard a vehicle other than an aircraft, such as a land-based or water-based vehicle, or a joint assembly of a different type of entity, such as a building, may be assessed.

In some embodiments, an assembly to be assessed may include one or more different types of component instead of or in addition to any of those described above with reference to Figures 1 and 2. For example, in some embodiments, a joint assembly includes further layers of material in addition to the first layer, the second layer, and the metallic shim described above. Also, in some embodiments, a joint assembly includes a different number of fasteners and/or a different type of fastener to that described above.

The digital model of the electrical circuit representative of (i.e. electrically equivalent to) the joint assembly may be different to that described above with reference to Figure 4. This digital model will depend on the properties and configuration of the components of the joint assembly of which the electrical circuit is representative.

In some embodiments, the starting conditions of the model of the electrical circuit are different to those used in the above embodiments. Starting conditions of the model may be determined so as to represent a certain states of the joint assembly, and a simulation process may be performed to establish how the joint assembly behaves in those different states.

**Claims**

1.   A method of providing an assessment of the effects of a lightning strike on an assembly (2, 20), the method comprising:

acquiring values for a plurality of physical properties of the assembly (2, 20);
using the acquired values, generating a digital model of an electrical circuit (22) representative of the assembly (2, 20);
applying, to the digital model, an input so as to simulate a predetermined current being applied to the electrical circuit (22), the predetermined current being a current generated by a lightning strike;
determining an effect of the input on at least a portion of the digital model; and,
using the determined effect, determining the assessment of the assembly (2, 20).

**2.** A method according to claim 1, wherein:

the digital model of the electrical circuit (22) comprises digital models of a plurality of electrical components selected from the group consisting of resistors, inductors, and capacitors; and

the electrical properties of the electrical components are determined using the acquired physical properties of the assembly (2, 20) such that the electrical circuit (22) is substantially electrically equivalent to the assembly (2, 20).

**3.** A method according to claim 1 or 2, wherein the method further comprises determining the predetermined current using a double exponential waveform having a magnitude and waveform that is determined by an assessment of an overall structure of which the assembly (2, 20) is a part.

**4.** A method according to claim 1 or 2, wherein the method further comprises determining the predetermined current by determining the number of parallel electrical paths that exist within an overall structure of which the assembly (2, 20) is a part from a lightning strike location to an exit location of the lightning current, and dividing a lightning current between those parallel paths.

**5.** A method according to any of claims 1 to 4, wherein the assembly (2, 20) is a joint assembly comprising at least two components (4, 6, 8) fixedly attached together.

**6.** A method according to claim 5, wherein the two components (4, 6, 8) are fixedly attached together by means of fasteners (12) passing at least partially through each of the at least two components (4, 6, 8) and/or by means of a sealant (10).

**7.** A method according to claim 5 or 6, wherein the joint assembly (2, 20) is an aircraft structural joint assembly that couples together two component parts of an aircraft substructure or airframe.

**8.** A method according to any of claims 1 to 7, wherein the step of acquiring values for a plurality of physical properties of the assembly (2, 20) comprises:

providing at least part of the assembly (2, 20); and

measuring, using a measurement device, the at least part of the assembly so as to determine values for one or more of the physical properties.

**9.** A method according to any of claims 1 to 8, wherein the method further comprises, using the assessment of the assembly (2, 20), modifying the assembly (2, 20).

**10.** A method according to any of claims 1 to 9, wherein at least one physical property of the assembly (2, 20) is a physical property selected from the group of physical properties consisting of: a physical dimension of at least part of the assembly (2, 20), a dielectric strength of at least part of the assembly (2, 20), a resistance through at least part of the assembly (2, 20), an inductance of at least part of the assembly (2, 20), a capacitance of at least part of the assembly (2, 20), a resistivity of at least part of the assembly (2, 20), a permittivity of at least part of the assembly (2, 20), a breakdown voltage of at least part of the assembly (2, 20), and a material from which of at least part of the assembly (2, 20) is made.

**11.** A method according to any of claims 1 to 10, wherein
at least part of the assembly (2, 20) is represented in the digital model by a plurality of nodes connected together in series and a plurality of nodes connected together in parallel; and
each node comprises a digital model of a resistor coupled to an inductor.

**12.** A method of comparing two or more assemblies, the method comprising:

for each assembly, determining an assessment of that assembly by performing, for that assembly, a method according to any of claims 1 to 11; and

using the determined assessments, determining a comparison of the assemblies.

**13.** Apparatus for providing an assessment of the effects of a lightning strike on an assembly (2, 20), the apparatus comprising:

means for acquiring values for a plurality of physical properties of the assembly (2, 20); and
one or more processors configured to:

using the acquired values, generate a digital model of an electrical circuit (22) representative of the assembly;
apply, to the digital model, an input so as to simulate a predetermined current being applied to the electrical circuit (22), the predetermined current being a current generated by a lightning strike;
determine an effect of the input on at least a portion of the digital model; and,
using the determined effect, determine the assessment of the assembly (2, 20).

14. A program or plurality of programs arranged such that when executed by a computer system or one or more processors it/they cause the computer system or the one or more processors to operate in accordance with the method of any of claims 1 to 12.

15. A machine readable storage medium storing a program or at least one of the plurality of programs according to claim 14.

# Fig. 1

# Fig. 2

# Fig. 3

```
           ┌─────────┐
           │  Start  │
           └────┬────┘
                │
                ▼
S2 ──┌──────────────────────────────────┐
     │       Provide Joint Assembly      │
     └──────────────┬───────────────────┘
                    │
                    ▼
     ┌──────────────────────────────────┐
     │  Determine Joint Assembly Properties │── S4
     └──────────────┬───────────────────┘
                    │
                    ▼
S6 ──┌──────────────────────────────────┐
     │   Create Model of Representative  │
     │        Electrical Circuit         │
     └──────────────┬───────────────────┘
                    │
                    ▼
     ┌──────────────────────────────────┐
     │       Input Lightning Pulse       │── S8
     │             to Model              │
     └──────────────┬───────────────────┘
                    │
                    ▼
S10 ─┌──────────────────────────────────┐
     │   Determine Effects of Lightning  │
     │          Pulse on Joint           │
     └──────────────┬───────────────────┘
                    │
                    ▼
     ┌──────────────────────────────────┐
     │       Modify Joint Assembly       │── S12
     └──────────────┬───────────────────┘
                    │
                    ▼
              ┌─────────┐
              │   End   │
              └─────────┘
```

Fig. 4

Fig. 5

Fig. 6

Europäisches
Patentamt

European
Patent Office

Office européen
des brevets

# EUROPEAN SEARCH REPORT

Application Number

EP 14 27 5004

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DANIEL PROST ET AL: "Lightning-Induced Current Simulation Using RL Equivalent Circuit: Application to an Aircraft Subsystem Design", IEEE TRANSACTIONS ON ELECTROMAGNETIC COMPATIBILITY, IEEE SERVICE CENTER, NEW YORK, NY, US, vol. 55, no. 2, 11 April 2013 (2013-04-11) , pages 378-384, XP011500122, ISSN: 0018-9375, DOI: 10.1109/TEMC.2012.2219868 * the whole document, in particular the abstract and sections I, IV and V * ----- | 1-15 | INV. G06F17/50 |
| A | L Chemartin ET AL: "Direct Effects of Lightning on Aircraft Structure: Analysis of the Thermal, Electrical and Mechanical Constraints", Journal Aerospace Lab - Issue 5, December 2012 (2012-12), pages 1-14, XP055118530, Retrieved from the Internet: URL:http://www.aerospacelab-journal.org/si tes/www.aerospacelab-journal.org/files/AL0 5-09_0.pdf [retrieved on 2014-05-16] * the whole document * ----- | 1-15 | TECHNICAL FIELDS SEARCHED (IPC) G06F |

The present search report has been drawn up for all claims

| Place of search | Date of completion of the search | Examiner |
|---|---|---|
| Munich | 19 May 2014 | Picallo Gonzalez, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................
& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **L. BOYER.** Contact Resistance Calculations: Generalizations of Greenwood's Formula Including Interface Films. *IEEE transactions on components and packaging technologies,* March 2001, vol. 24 (1

- **E. ROSA.** The self and mutual inductance of linear conductors. *Bull., National Bureau of Standards,* 1908, 301-344